# EUROPEAN PATENT APPLICATION

(11) **EP 1 801 858 A1**
(43) Date of publication of application: **27.06.2007**
(21) Application number: 06126715.9
(22) Date of filing: 20.12.2006
(51) Int. Cl.: H01L 21/28, H01L 21/336

(54) **Method for gate electrode height control**

(30) Priority: 23.12.2005 EP 05447291
(71) Applicant: INTERUNIVERSITAIR MICROELEKTRONICA CENTRUM vzw (IMEC), 3001 Leuven (BE)
(72) Inventor: Veloso, Anabela, 3001, LEUVEN (BE)
(74) Representative: Van Malderen, Joëlle

(57) **Abstract**

The present invention relates to a method for controlling the gate electrode in a silicidation process, comprising the steps of:
- applying a sacrificial cap layer (18) on top of each of at least one gate electrode (13), each of the at least one gate electrode deposited with a given height on a semiconductor substrate (10),
- applying an additional layer of oxide (14) on top of said sacrificial layer
- covering with a material (17) said semiconductor substrate (10) provided with said at least one gate electrode (13) having said sacrificial cap layer (18) with said additional oxide layer (14) on top,
- performing a CMP planarisation step,
- removing at least said material (17) and said additional layer of oxide (14) until on top of each of the at least one gate electrode (13) the sacrificial cap layer (18) is exposed,
- removing the sacrificial cap layer (18) from each of the at least one gate electrode (13), yielding each of the at least one gate electrode (13) still having the given height.

## Description

### Field of the invention

The present invention relates to the field of the fabrication of silicided gate devices by means of a CMP integration scheme.

### State of the art

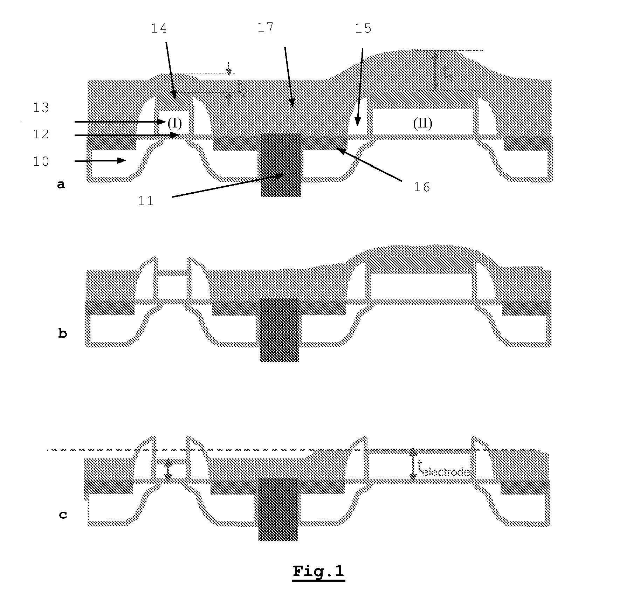

CMP is a method of removing layers of solid by chemical-mechanical polishing carried out for the purpose of surface planarisation. In a chemical-mechanical polishing (CMP) scheme after the planarisation step, the material (e.g. oxide) covering the wafer is thinner on top of smaller structures (t₂) than on top of larger structures (t₁), as illustrated in Figure 1. This is a characteristic feature of a CMP process. This CMP non-uniformity within-die and also within-wafer has an impact on the dry etch process that clears the oxide from the top of the poly-Si gates, while leaving the source/drain (S/D) areas covered by oxide. Indeed, to guarantee that oxide on top of all gate electrodes (small and large) is removed (which constitutes an essential condition to (fully) silicide the gates later on), an over-etch time has to be applied. The higher the non-uniformity values, the longer the over-etch time needs to be. This puts stricter constraints on the dry etch process, since a very high etch rate selectivity of the gate electrode material (e.g. poly-Si) vs. that of the material (e.g. oxide) covering the devices is then required. If, for example, there is still an oxide layer of a certain thickness on top of some gate electrodes, while some other devices are already oxide cleared out, then the dry etch selectivity towards the gate electrode should be very high to ensure that all gate electrodes end up with the same final height.

Figure 1 schematically represents the process flow showing the CMP non-uniformity problem encountered in the prior art. On a semiconductor substrate (10), shallow trench isolation (STI) regions (11) are defined, followed by gate stack patterning. Gate structures with different lengths were defined as shown in Fig. 1a: (I) small gate; (II) large gate. The conventional gate stack consists of a thin gate dielectric layer (12), a gate electrode (13) and an additional layer (14). After gate patterning, spacers (15) definition and silicidation of the source and drain regions (16), a material (17) is deposited in order to planarize the structures prior to the chemical-mechanical-polishing (CMP). After the CMP, the non-uniformity of the remaining material is illustrated by the different values of the thickness on top of the large gates (t1) and the small gates (t2), with t1 > t2 as shown in Fig.1a. Fig.1b shows schematically the exposed gate electrode on the small gate (I) after the oxide etch-back step. During the over-etch step neede to clear out the material (17) and the additional layer (14) from the larger gate structures, the gate electrode (13) from the small gates (I) is partially consumed, whereas on the large gates (II) the initial t_{electrode} thickness is still present as illustrated in Fig. 1c.

The CMP non-uniformity could possibly be improved with the use of a liner (stop CMP liner). The problem with implementing this alternative approach is in the choice of the material (s) to use as liner, such that the spacers integrity is not compromised and the process complexity is not increased (as if a liner with multiple layers were chosen). A nitride stop CMP liner as disclosed by Wong et al. in US5731239 does not completely solve the non-uniformity problem after CMP and limits the choice of spacer material to oxide. In this case, if nitride spacers were used, their integrity would be affected by the liner removal step.

### Aims of the invention

The present invention aims to provide a method for controlling the height of gate electrodes in a silicidation process.

### Summary of the invention

The present invention relates to a method for controlling the gate electrode height in a silicidation process. The method comprises the steps of:
- applying a sacrificial cap layer on top of each of at least one gate electrode, each of the at least one gate electrode deposited with a given height on a semiconductor substrate,
- applying an additional layer of oxide on top of said sacrificial layer,
- covering with a material the semiconductor substrate provided with said at least one gate electrode having said sacrificial cap layer with said additional layer of oxide on top,
- performing a chemical-mechanical polishing (CMP) planarisation step,
- removing at least said material and said additional layer of oxide until on top of each of the at least one gate electrode the sacrificial cap layer is exposed,
- removing the sacrificial cap layer from each of the at least one gate electrode, yielding each of the at least one gate electrode still having the given height.

Advantageously the method further comprises a step of patterning the sacrificial cap layer and of encapsulating with spacers the gate electrode, provided with the sacrificial cap layer on top and, optionally, with the additional layer of oxide.

Preferably the method further comprises a step of siliciding the at least one gate electrode still having the given height.

In another preferred embodiment the at least one gate electrode is in poly-Silicon or in amorphous silicon. The sacrificial cap layer preferably is in SiGe. Alternatively, it may be in any material with a slower etch rate than the material used to cover the semiconductor substrate. Advantageously, the sacrificial cap layer is removed with a wet etch.

The material for covering the semiconductor substrate is advantageously oxide or phosphosilicate glass.

### Short description of the drawings

Fig. 1 represents the CMP non-uniformity problem encountered in the prior-art: (a) after CMP; (b) after oxide etch back until the exposure of the gate electrode on the small gates; (c) after further oxide etch back (over-etch) until the exposure of the gate electrode on the large gates.

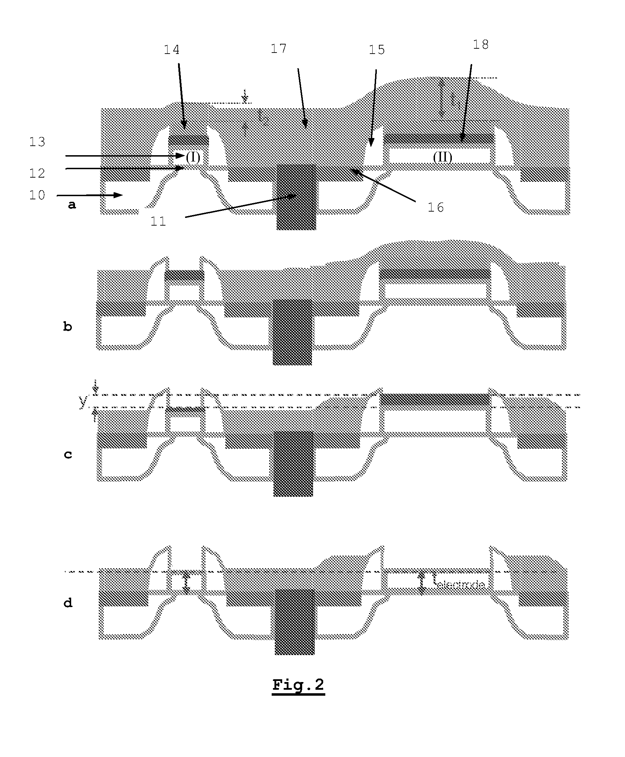

Fig. 2 represents the steps of the method according to the present invention:(a) after CMP; (b) after oxide etch back until the exposure of the sacrificial layer on the small gates; (c) after further oxide etch back (over-etch) until the exposure of the sacrificial layer on the large structures; (d) after selective removal of the sacrificial layer.

### Detailed description of the invention

Figure 2 schematically shows the steps of the method according to the present invention. In the solution according to the present invention a sacrificial cap layer (18) (e.g. in SiGe) is used on top of the gate electrode (13) (e.g. poly-silicon), (possibly) encapsulated by the spacers(15). The sacrificial layer (18) has an initial thickness t_{SiGe} and can be removed with high selectivity (e.g. by wet etch) with respect to the gate electrode (13), the spacers (15) and the oxide covering the S/D silicide (17).

Fig. 2a illustrates the within-wafer and within-die non-uniformity of the material (17) after CMP. The remaining thickness of the material on top of the small gates (t2) is typically lower than the thickness of the remaining material on top of the large gates (t1), with t1 > t2.

By performing an oxide etch back, both the remaining material (17) and the additional layer (14) are removed until the sacrificial layer (18) on the small gates is exposed as illustrated in Fig. 2b. End point detection is used to detect the exposure of the sacrificial layer (18) on the small gates (I).

Next, an overetch step is performed until the complete oxide clear-out is achieved on the large gates (II), with full exposure of the sacrificial layer (18).
As described in Fig. 2c, during the etch back step, the within-wafer and within-die non-uniformity of the oxide layer (from CMP) implies that, in some locations, no sacrificial layer is etched away while in other locations a layer of a thickness y (with y < t_{SiGe}) is etched away. The sacrificial layer (18) does thus not act as a stop layer.

The sacrificial layer within-wafer and within-die non-uniformity, after the oxide clear-out of the gates, does not pose a problem, because all sacrificial material remaining on the wafers is then removed (by wet etch) very selectively to all other materials present in the wafers as shown in Fig. 2d. After removing the sacrifical layer, the silicidation (optionally a full silicidation) of the gates is then performed in gate electrodes with a controlled height (i.e. the deposited gate electrode thickness).

In a preferred embodiment the gate electrode is polysilicon and the removal process is a selective wet etch.

By employing the sacrificial layer and the method as described above, an excellent control of the poly gate electrode and spacer height is achieved. As shown in Fig. 2d the initial thickness of the polysilicon gate electrode (t_{electrode}) is kept all over the different gate lengths.

A sacrificial cap layer (for example in SiGe) can also be interesting for obtaining devices with higher spacers height as compared to the gate electrode height prior to the gate silicidation. This allows
- better control of the amount of metal (e.g. Ni) accessing the gate electrode prior to the (full) silicidation of the gate, hence leading to a better silicide phase control down to smaller gate lengths, and
- nicely containing the (fully) silicided gate inside the spacers after the volume expansion occurring during full silicidation of the gates. The volume expansion is even more severe for metal-rich silicides).

The approach according to the present invention offers many advantages. After the sacrificial layer removal, smaller and bigger devices with identical gate electrode height are obtained everywhere on the wafer. This is an essential factor to guarantee FUSI phase control down to small gate lengths. The process sensitivity to the inherent non-uniformity (within-die) of CMP is substantially reduced. Also, a smaller sensitivity to within-wafer CMP non-uniformity is thus obtained. As a consequence, a more relaxed CMP process can be used in the fabrication of FUSI CMOS devices. Linked with this, less tight constraints are required for the selectivity ratios in the dry etch process used to clear out the oxide from the gate electrodes. All these elements contribute in obtaining a more robust (enhanced manufacturability) process for FUSI integration.

The method according to the invention adds one extra process step to the process flow for the removal of the sacrificial cap layer. However, since the removal is highly selective, it is a simple, fast processing step.

## Claims

1. Method for controlling the gate electrode height in a silicidation process, comprising the steps of:
- applying a sacrificial cap layer (18) on top of each of at least one gate electrode (13), each of said at least one gate electrode deposited with a given height on a semiconductor substrate (10),
- applying an additional layer of oxide (14) on top of said sacrificial layer (18)
- covering with a material (17) said semiconductor substrate (10) provided with said at least one gate electrode (13) having said sacrificial cap layer (18) with said additional layer of oxide (14) on top,
- performing a chemical-mechanical polishing (CMP) planarisation step,
- removing at least said material (17) and said additional layer of oxide (14) until on top of each of said at least one gate electrode (13) said sacrificial cap layer (18) is exposed,
- removing said sacrificial cap layer (18) from each of said at least one gate electrode (13), yielding each of said at least one gate electrode (13) still having said given height.

2. Method for controlling the gate electrode height as in claim 1, wherein a step is performed of patterning and of encapsulating with spacers (15) said gate electrode (13), provided with said sacrificial cap layer (18) on top and with said additional layer of oxide (14).

3. Method for controlling the gate electrode height as in any of claims 1 or 2, further comprising a step of siliciding said at least one gate electrode (13) still having said given height.

4. Method for controlling the gate electrode height as in any of the previous claims, wherein said at least one gate electrode (13) is in poly-silicon or in amorphous silicon.

5. Method for controlling the gate electrode height as in any of the previous claims, wherein said sacrificial cap layer (18) is in SiGe.

6. Method for controlling the gate electrode height as in any of the previous claims, wherein said sacrificial cap layer (18) is removed with a wet etch.

7. Method for controlling the gate electrode height as in any of the previous claims, wherein said material (17) for covering said semiconductor substrate (10) is oxide or phosphosilicate glass.
